**Europäisches Patentamt**

**European Patent Office**

**Office européen des brevets**

(19)

(11) Veröffentlichungsnummer: **0 240 875 B1**

# EUROPÄISCHE PATENTSCHRIFT

(12)

(45) Veröffentlichungstag der Patentschrift: **20.02.91**

(51) Int. Cl.5: **G01R 27/20, G01R 27/14**

(21) Anmeldenummer: **87104602.5**

(22) Anmeldetag: **27.03.87**

(54) **Prüfeinrichtung für den Übergangswiderstand von Anschlussklemmen über die ein Energiespeicher mit einem elektrischen Gerät verbunden ist.**

(30) Priorität: **07.04.86 DE 3611562**

(43) Veröffentlichungstag der Anmeldung:
**14.10.87 Patentblatt 87/42**

(45) Bekanntmachung des Hinweises auf die
Patenterteilung:
**20.02.91 Patentblatt 91/08**

(84) Benannte Vertragsstaaten:
**AT BE DE ES FR GB IT NL SE**

(56) Entgegenhaltungen:
**US-A- 3 731 189**

**ELEKTRONIK, Band 35, Nr. 3, Februar 1986,
Seiten 79-80, München, DE; R. WENDERS:
"Messung kleinster Widerstände"**

(73) Patentinhaber: **Siemens Aktiengesellschaft
Wittelsbacherplatz 2
D-8000 München 2(DE)**

(72) Erfinder: **Neugebauer, Dieter
Am grasigen Weg 12
D-8413 Regenstauf(DE)**

EP 0 240 875 B1

EP 0 240 875 B1

## Beschreibung

Die Erfindung betrifft eine Prüfeinrichtung gemäß Oberbegriff von Anspruch 1. Ein Energiespeicher, z.B. eine Stützbatterie, eine Hilfsstromversorgung oder eine Pufferkondensator, ist mit dem zugeordneten elektrischen Gerät oft über Anschlußklemmen verbunden, die einen einfachen Austausch des Energiespeichers ermöglichen.

Die Erfindung geht von der Feststellung aus, daß die Übergangswiderstände der Anschlußklemmen solcher Energiespeicher sich durch fehlerhaften Austausch oder Kcrrosion teilweise so stark vergrößern, daß die Funktion des Energiespeichers in Frage gestellt wird. Dieser Effekt zeigt sich insbesondere bei Energiespeichern, die nur zur gelegentlichen oder sogar einmaligen Stromentnahme bestimmt sind und über die daher über längere Zeiträume keine Stromentnahme erfolgt.

Der Erfindung liegt daher die Aufgabe zugrunde, bei einer Prüfeinrichtung der eingangs genannten Art die Übergangswiderstände der Anschlußklemmen des Energiespeichers in einfacher Weise zu überwachen.

Bei der erfindungsgemäßen, in Anspruch 1 gekennzeichneten Lösung dieser Aufgabe, ist das Prüfteil ein Serienzweig, der aus einem Schalter und einem ohmschen Widerstand besteht. Als Schalter kommen alle Arten von mechanischen sowie elektromagnetischen Schaltern und auch Halbleiterschalter in Frage. Die Betätigung des Schalters kann manuell erfolgen oder auch durch einen Befehlsgeber, der den schalterspezifischen Steuerbefehl gibt.

Der Meßvorgang läuft folgenderaßen ab: Bei offenem Schalter liegt über dem Serienzweig die volle Spannung des Energiespeichers, da im Serienzweig kein Strom fließen kann. Erst nach Schließen des Schalters fließt ein Strom vom Energiespeicher über die Übergangswiderstände seiner Anschlußklemmen und über den Widerstand des Serienzweigs. Der dadurch entstehende Spannungssprung am Serienzweig wird von einem Auswerter erfaßt, der daraus die Größe der Übergangswiderstände der Anschlußklemmen berechnet.

Der Auswerter könnte z.B. eine Schwellwertstufe sein, die die Spannung am Serienzweig abgreift. Die Schwellwertstufe ist z.B. so eingestellt, daß sie anspricht, wenn die Übergangswiderstände und damit der Spannungssprung am Serienzweig einen zulässigen Grenzwert überschreitet. Damit signalisiert das Ansprechen der Schwellwertstufe, daß die Übergangswiderstände zu groß sind. Ein weiterer Vorteil der vorgeschlagenen Prüfeinrichtung besteht darin, daß die Höhe der Spannung des Energiespeichers in die Übergangswiderstandsmessung eingeht und somit auch überwacht werden kann.

Aus der US-A-3731189 ist eine Prüfeinrichtung zur Messung des Widerstandes eines Elements während dessen Betriebs bekannt. Diese Prüfeinrichtung weisteinen Serienzweig auf, der einen Schalter und den zu messenden Widerstand enthält. Dabei sind Mittel vorgesehen, un den Schalter zu betätigen, wobei beim Schließen dieses Schalters ein Spannungssprung an dem Serienzweig auftritt. Dieser Spannungssprung wird dann in einen an den Serienzweig angeschlassenen Auswerter weitergeleitet, so daß dort aus dem Spannungssprung ein Maß für den zu messenden Widerstand ermittelt werden kann.

Die Erfindung wird anhand eines Ausführungsbeispieles näher erläutert. Dabei zeigen:

FIG 1    die elektrische Schaltung des Ausführungsbeispieles,

FIG 2    eine Spannungsmasche bei offenem Schalter,

FIG 3    eine Spannungsmasche unmittelbar nach Schließen des Schalters.

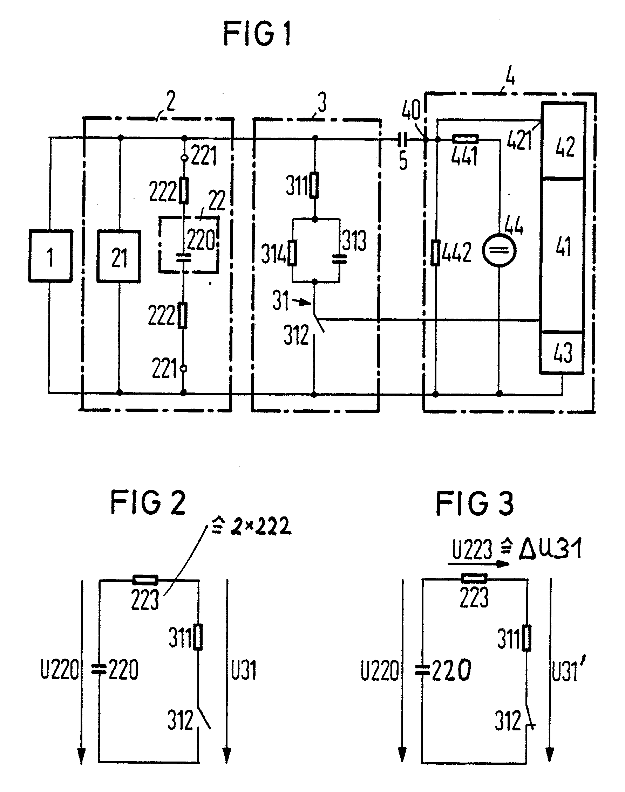

In FIG 1 ist das elektrische Gerät 1 die Auslöseschaltung für ein Kfz-Airbag-System. Die Zündenergie zum Auslösen des Airbags liefert eine Energiequelle 2. Sie enthält eine Kaskadenschaltung 21 und einen an dieser parallel angeschlossenen Kondensator 220 als Energiespeicher 22, der als Elektrolytkondensator ausgebildet ist. Die Kaskadenschaltung 21 transformiert die Gleichspannung einer Kfz-Batterie auf einen ausreichend hohen Wert und stellt eine Spannungsquelle mit so hohem Innenwiderstand dar, daß sie zwar den Kondensator 220 mit großer Zeitkonstante aufladen kann, aber nicht in der Lage ist, die Leistung für die Zündung des Airbag-Systems zu liefern. Aus demselben Grund wird auch bei der folgenden Beschreibung des Prüfablaufs ihr Einfluß vernachlässigt.

Als Energiespeicher 22 für die Zündenergie des Airbag-Systems dient also ausschließlich der geladene Kondensator 220. Aufgrund begrenzter Lebensdauer wird er als austauschbares Teil über Anschlußklemmen 221 mittels Schraubverbindungen angeschlossen. Da das Vorhandensein sowie die niederohmige Einbindung des Kondensators 220 Voraussetzung für die Funktion des Airbag-Systems ist, besteht die Notwendigkeit, die Teilübergangswiderstände 222 der Anschlußklemmen 221 zu überwachen. Im folgenden wird als Übergangswiderstand 223 der Widerstand verstanden, der der Summe der beiden Teilwiderstände 222 der beiden Anschlußklemmen 221 entspricht.

Der Überwachungsteil für den Übergangswiderstand 223 besteht aus einem Prüfteil 3 und einem Auswerter 4 mit einem Eingang 40. Der Eingang 40 ist über einen Koppelkondensator 5 mit dem Prüfteil 3 verbunden.

Das Prüfteil 3, das dem Kondensator 220 parallel geschaltet ist, besteht aus einem Serienzweig 31, der einen Widerstand 311, einen Schalter 312 sowie eine Parallelschaltung aus einem Kondensator 313 und einem Widerstand 314 umfaßt. Im Beispiel ist der Schalter 312 ein Transistor. Er ist im Normalbetrieb gesperrt und wird nur zum Messen kurzzeitig vom Auswerter 4 her leitend geschaltet.

FIG 2 zeigt die Spannungsmasche über den Kondensator 220, seinen Übergangswiderstand 223 und den Serienzweig 31 bei offenem Schalter 312 und FIG 3 dieselbe Spannungsmasche umittelbar nach Schließen des Schalters 312. Der Vergleich der zustände von FIG 2 und FIG 3 zeigt, daß am Serienzweig 31 ein Spannungssprung $\Delta$ U31 auftritt, der dem Spannungsabfall U223 am Übergangswiderstand 223 gleich ist. Formelmäßig ergibt sich:

$$U223 = \Delta U31 = U220 \; \frac{R223}{R223 + R311} \qquad (1)$$

Der Spannungssprung $\Delta$ U31, der beim Messen auftritt, erlaubt also die direkte Berechnung des Übergangswiderstandes 223.

Die Auswertegenauigkeit und die Sicherheit der Auswertung hängt von der Größe des Spannungssprungs $\Delta$ U31 und diese von dem Widerstand 311 des Serienzweigs 31 ab. Gleichung 1 in anderer Schreibweise lautet:

$$\Delta U31 = U220 \; \frac{1}{1 + \frac{R311}{R223}} \qquad (2)$$

Der Spannungssprung $\Delta$ U31 wird demnach umso größer, desto kleiner

$$\frac{R311}{R223}$$

ist. Da auch unzulässige Werte des Übergangswiderstandes 223 noch sehr klein sind, wählt man den Widerstand 311 ungefähr in der Größenordnung dieses unzu lässigen Übergangswiderstands 223, um einen deutlichen Spannungssprung $\Delta$ U31 zu erhalten. Diese Dimensionierung ergäbe bei der Messung jedoch einen großen Strom durch den Serienzweig 31 und damit eine große Belastung des Kondensators 220 und des Transistors.

Abhilfe schafft hier eine Weiterbildung der Erfindung, nämlich die im Serienzweig 31 enthaltene Parallelschaltung aus dem Kondensator 313 und dem Widerstand 314. Der kleindimensionierte Kondensator 313 stellt im ersten Augenblick nach Schließen des Schalters 312 einen Kurzschluß dar, so daß er die eigentliche Messung nicht behindert. Da er jedoch schnell geladen ist, unterbricht er den Stromfluß wieder. Über den Serienkreis 31 kann dann nur noch ein kleiner Reststrom über den groß bemessenen Parallelwiderstand 314 fließen. Nachdem der Transistor den Serienkreis 31 wieder unterbricht, entlädt sich der Kondensator 313 über seinen Parallelwiderstand 314 und stellt so den Ausgangszustand wieder her.

Der Auswerter 4 enthält einen Mikroprozessor 41, dem eingangsseitig ein Analogdigitalwandler 42 mit einem Eingang 421 vorgeschaltet ist. Der Analogdigitalwandler 42 verlangt eine Referenzspannung, die mit Hilfe einer Spannungsquelle 44 und eines Spannungsteilers, bestehend aus den Widerständen 441 und 442, gebildet wird. An dem Eingang 421 liegt somit diese Referenzspannung und ihr überlagert der Spannungssprung vom Serienzweig 31. Der Koppelkondensator 5 trennt bei offenem Schalter 312, die Potentiale der Referenzspannung und der Spannung am Kondensator 220.

Ein Ausgang des Mikroprozessors 41 ist an die Basis des Transistors gelegt, der im Prüfteil als Schalter 312 verwendet ist. Eine Einzelmessung des Übergangswiderstan des 223 geschieht durch einmaliges Durchschalten und anschließendes Sperren des Transistors über diesen Ausgang. Der Mikroprozessor 41 führt fünf solcher Einzelmessungen in kurzem Abstand nacheinander aus und bildet daraus einen Mittelwert. Diese Mittelwertbildung hat den Vorteil, etwaige Fehler, die bei Einzelmessungen auftreten können, zu eliminieren. Das Meßergebnis wird schließlich mit einem Grenzwert verglichen und ein Meldesignal erzeugt, wenn der Meßwert den Grenzwert überschreitet, der Übergangswiderstand 223 also einen unzulässigen Wert annimmt. Durch das Meldesignal wird ein Anzeigeteil 43 mit einer LED so angesteuert, daß ein Aufleuchten der LED einen ordnungsgemäßen Übergangswiderstand 223 signalisiert.

Ein weiterer Vorteil der Prüfeinrichtung, nämlich der geringe Energieverbrauch einer Einzelmessung, erlaubt es, die Meßintervalle periodisch zu wiederhohen. Der Mikroprozessor 41 führt alle zehn Sekunden ein Meßintervall durch, d.h. der Übergangswiderstand 223 wird periodisch überwacht und damit die Betriebssicherheit des Airbag-Systems wesentlich verbessert.

Begriffsliste

1 Gerät
Airbag-System
2 Energiequelle
21 Kaskadenschaltung
22 Energiespeicher
220 Kondensator
221 Anschlußklemme
222 Teilübergangswiderstand
223 Übergangswiderstand
3 Prüfteil
31 Serienzweig
311 Widerstand
312 Schalter
Transistor
313 Kondensator
314 Widerstand
5 Koppelkondensator
4 Auswerter
40 Eingang
41 Mikroprozessor
42 A/D-Wandler
421 Eingang
43 Anzeigeteil
44 Spannungsquelle
441, 442 Widerstand

## Ansprüche

1. Prüfeinrichtung für den Übergangswiderstand (223) von Anschlußklemmen (221), über die ein Energiespeicher (22) mit einem elektrischen Gerät (1) verbunden ist,
**dadurch gekennzeichnet,**
daß ein Prüfteil (3) über die Anschlußklemmen (221) zum Energiespeicher (22) parallel geschaltet ist,
daß das Prüfteil 93) einen Serienzweig (31) mit einem Schalter (312) und einem Widerstand (311) enthält,
daß Mittel vorgesehen sind zum Betätigen des Schalters (312), wobei beim Schließen des Schalters (312) ein Spannungssprung an dem Serienzweig (31) auftritt,
daß ein Ende des Serienzweigs (31) des Prüfteils (3) an einem Eingang (40) eines Auswerters (4) angeschlossen ist, der aus dem Spannungssprung am Serienzweig (31) ein Maß für den Übergangswiderstand (223) ermittelt, und daß das andere Ende des Serienzweigs (31) des Prüfteils (3) an dem anderen Eingang des Auswerters (4) angeschlossen ist.

2. Prüfeinrichtung nach Anspruch 1, **dadurch gekennzeichnet,** daß der Serienzweig (31) zusätzlich einen Kondensator (313) mit parallelgeschaltetem Widerstand (314) enthält.

3. Prüfeinrichtung nach Anspruch 1 oder 2, **dadurch gekennzeichnet,** daß der Auswerter (4) einen Mikroprozessor (41) enthält, der auch den Schalter (312) des Prüfteils (3) steuert.

4. Prüfeinrichtung nach Anspruch 3, **dadurch gekennzeichnet,** daß das Prüfteil (3) über ei nen Koppelkondensator (5) an den einen Eingang (40) des Auswerters (4) angeschlossen ist.

5. Prüfeinrichtung nach Anspruch 1, **dadurch gekennzeichnet,** daß der Energiespeicher (22) ein Kondensator (220) ist.

6. Prüfeinrichtung nach Anspruch 1, **dadurch gekennzeichnet,** daß der Schalter (312) ein Transistor ist.

## Claims

1. Test device for the contact resistance (223) of terminals (221) via which an energy storage device (22) is connected to an electrical device (1), characterized in that a test component (3) is connected via the terminals (221) in parallel to the energy storage device (22), in that the test component (3) contains a series branch (31) having a switch (312) and a resistor (311), and in that means are provided for actuating the switch (312), a voltage jump occurring at the series branch (31) when said switch (312) is closed, in that one end of the series branch (31) of the test component (3) is connected to an input (40) of an evaluator (4) which determines a measure for the contact resistance (223) from the voltage jump at the series branch (31), and in that the other end of the series branch (31) of the test component (3) is connected to the other input of the evaluator (4).

2. Test device according to Claim 1, characterized in that the series branch (31) additionally contains a capacitor (313) with resistor (314) connected in parallel.

3. Test device according to Claim 1 or 2, characterized in that the evaluator (4) contains a microprocessor (41) which also controls the switch (312) of the test component (3).

4. Test device according to Claim 3, characterized in that the test component (3) is connected via a coupling capacitor (5) to the one input (40) of the evaluator (4).

5. Test device according to Claim 1, characterized in that the energy storage device (22) is a capacitor (220).

6. Test device according to Claim 1, characterized in that the switch (312) is a transistor.

## Revendications

1. Dispositif d'essai pour une résistance de contact (223) de bornes de raccordement (221), par l'intermédiaire desquelles un accumulateur d'énergie (22) est relié à un appareil électrique (1), caractérisé par le fait qu'une unité d'essai (3) est branchée en parallèle avec l'accumulateur d'énergie (24), par l'intermédiaire des bornes de raccordement (221),
que l'unité d'essai (3) contient une branche série (31) incluant un interrupteur (312) et une résistance (311), qu'il est prévu des moyens pour actionner l'interrupteur (312), auquel cas, lors de la fermeture de cet interrupteur (312), un saut de tension apparaît dans la branche série (31),
qu'une extrémité de la branche série (31) de l'unité d'essai (3) est raccordée à une entrée (40) d'un dispositif d'évaluation (4), qui détermine, à partir du saut de tension dans la branche série (31), une mesure de la résistance de contact (223), et
que l'autre extrémité de la branche série (31) de l'unité d'essai (3) est raccordée à l'autre entrée du dispositif d'évaluation (4).

2. Dispositif d'essai suivant la revendication 1, caractérisé par le fait que la branche série (31) contient en outre un condensateur (313) en parallèle, avec lequel est branchée une résistane (314).

3. Dispositif d'essai suivant la revendication 1 ou 2, caractérisé par le fait que le dispositif d'évaluation (4) contient un microprocesseur (41) qui commande également l'interrupteur (312) de l'unité d'essai (3).

4. Dispositif d'essai suivant la revendication 3, caractérisé par le fait que l'unité d'essai (3) est raccordée par l'intermédiaire d'un condensateur de couplage (5) à une entrée (40) du dispositif d'évaluation (4).

5. Dispositif d'essai suivant la revendication 1, caractérisé par le fait que l'accumulateur d'énergie (21) est un condensateur (220)

6. Dispositif d'essai suivant la revendication 1, caractérisé par le fait que l'interrupteur (312) est un transistor.

# FIG 1

# FIG 2

# FIG 3